# EUROPÄISCHE PATENTSCHRIFT

(11) **EP 2 267 899 B1**
(45) Veröffentlichungstag und Bekanntmachung des Hinweises auf die Patenterteilung: **12.06.2019**
(21) Anmeldenummer: 10004515.2
(22) Anmeldetag: 29.04.2010
(51) Int. Cl.: H03L 7/081, H03L 7/087, H03K 5/135

(54) **Vorrichtung zum Erzeugen einer vorgegebenen Phasenverschiebung**
Device for generating a pre-defined phase shift
Dispositif de production d'un décalage de phase prédéterminé

(30) Priorität: 23.06.2009 DE 102009030039
(43) Veröffentlichungstag der Anmeldung: 29.12.2010
(73) Patentinhaber: Rohde & Schwarz GmbH & Co. KG, 81671 München (DE)
(72) Erfinder: Dümler, Ulrich, 45478 Mülheim (DE)
(74) Vertreter: Körfer, Thomas

(56) Entgegenhaltungen:
- DE-A1-102005 007 652
- DE-A1-102005 008 151
- LOVALACE D ET AL: "A self calibrating quadrature generator with wide frequency range" RADIO FREQUENCY INTEGRATED CIRCUITS (RFIC) SYMPOSIUM, 1997., IEEE DENVER, CO, USA 8-11 JUNE 1997, NEW YORK, NY, USA,IEEE, US LNKD- DOI:10.1109/RFIC.1997.598763, 8. Juni 1997 (1997-06-08), Seiten 147-151, XP010231146 ISBN: 978-0-7803-4063-3
- JOHNSON M G ET AL: "A VARIABLE DELAY LINE PLL FOR CPU-COPROCESSOR SYNCHRONIZATION" IEEE JOURNAL OF SOLID-STATE CIRCUITS, IEEE SERVICE CENTER, PISCATAWAY, NJ, US LNKD- DOI:10.1109/4.5947, Bd. 23, Nr. 5, 1. Oktober 1988 (1988-10-01), Seiten 1218-1223, XP000570887 ISSN: 0018-9200

## Beschreibung

Die Erfindung betrifft eine Vorrichtung zum Erzeugen einer vorgegebenen Phasenverschiebung zwischen zwei Ausgangssignalen. Eine solche bestimmte Phasendrehung wird beispielsweise zur Ansteuerung eines I/Q-Modulators benötigt. Ein I/Q-Modulator benötigt ein Oszillatorsignal, welches einem Mischer eines Inphase-Signalverarbeitungspfades mit 0° zugeführt wird und einem Mischer eines Quadraturphase-Signalverarbeitungspfads mit 90° Phasenverschiebung zugeführt wird. Die beiden zugeführten Oszillatorsignale müssen daher kohärent zueinander sein und es muss eine Zeitverzögerung zwischen diesen Signalen von exakt einer viertel Periode vorliegen.

Zur Erzeugung einer bestimmten Phasenverzögerung wird bei digitaler Implementierung oft eine sogenannte Delay-Locked-Loop (DLL), d.h. eine rastende Verzögerungsschleife, benutzt. Eine solche Delay-Locked-Loop ist beispielsweise aus der US 2009/0045857 A1 bekannt. Bei der aus dieser Druckschrift hervorgehenden DLL-Schaltung wird das Signal nach einem Taktpuffer einer Multiphasenverzögerungsleitung zugeführt und diese besteht aus einer Kette von Verzögerungselementen. Nach jedem Verzögerungselement besteht ein Abgriff, der einem Phasen-Controller zugeführt wird. Die Phasenverzögerung jedes einzelnen Verzögerungselements ist einstellbar und wird mit einem Multiphasenverzögerungs-Controller eingestellt, der ein Steuersignal von dem Phasen-Controller erhält. Nachteilig an dieser Konfiguration ist, dass das Ausgangssignal fest am Ende der Kette der Verzögerungselemente abgegriffen wird und die Gesamtverzögerung nur dadurch einstellbar ist, dass die Verzögerungszeit sämtlicher Verzögerungselemente der Verzögerungs-Kette verändert wird. Die Anzahl der Verzögerungselemente in der Verzögerungs-Kette ist jedoch nicht variabel. Dies hat zunächst den Nachteil, dass der Bereich der Verzögerung, welcher mit der Verzögerungs-Kette darstellbar ist, sehr begrenzt ist. Nachdem stets alle Verzögerungselemente der Verzögerungskette in Betrieb sind, erzeugt diese Schaltung ein relativ großes Eigenrauschen. Außerdem kann die Schaltung nicht breitbandig ausgelegt werden. Durch den Betrieb der vielen Verzögerungs-Elemente entsteht auch eine relativ hohe Verlustleistung, die insbesondere bei Ausbildung in Form einer integrierten Schaltung abgeführt werden muss.

Eine Vorrichtung nach dem Oberbegriff des Patentanspruchs 1 geht aus der DE 10 2005 007652 A1 hervor. Dieses Dokument offenbart eine DLL-Schaltung zum Bereitstellen eines Ausgangssignals, das bezüglich eines periodischen Eingangssignals um eine gewünschte Phasenverschiebung verschoben ist, mit einer Anzahl von Verzögerungselementen mit jeweils gleicher Verzögerungszeit, die in Reihe zu einer Verzögerungskette verschaltet sind, wobei an das erste Verzögerungselement der Verzögerungskette das periodische Eingangssignal angelegt ist, mit einer Detektionseinheit, die mit Ausgängen zumindest eines Teils der Verzögerungselemente verbunden ist und vorgesehen ist, um festzustellen, bis zu welchem Verzögerungselement eine bestimmte Flanke des periodischen Signals nach einem vorgegebenen Phasenfortschritt des periodischen Signals gelangt ist, und um eine entsprechende Steuerinformation zu generieren, die angibt, an welchem der Verzögerungselemente die bestimmte Flanke des periodischen Signals zuletzt bestimmt wurde, und mit einer Auswahlschaltung, die abhängig von der Steuerinformation und abhängig von der gewünschten Phasenverschiebung eines der Verzögerungselemente auswählt und das Signal am Ausgang des ausgewählten Verzögerungselementes als das Ausgangssignal der DLL-Schaltung ausgibt.

Der Erfindung liegt deshalb die Aufgabe zugrunde, eine Vorrichtung zum Erzeugen einer vorgegebenen Phasenverschiebung zwischen zwei Ausgangssignalen zu schaffen, welche möglichst rauscharm ist, die über einen großen Frequenzbereich betrieben werden kann, welche eine niedrige Verlustleistung erzeugt und welche signalformunabhängig ist, d.h. die Funktion der Schaltung sollte unabhängig von der Signalform des ansteuernden Signalgenerators sein.

Die Aufgabe wird durch die Merkmale des Patentanspruchs 1 gelöst. Die abhängigen Patentansprüche betreffen vorteilhafte Weiterbildungen der erfindungsgemäßen Vorrichtung.

Auch die erfindungsgemäße Vorrichtung besteht aus einer Verzögerungs-Kette aus mehreren seriell hintereinander angeordneten Verzögerungs-Gliedern. Im Unterschied zum Stand der Technik sind jedoch mehrere Phasendetektoren vorhanden, die jeweils die Phasendifferenz zwischen dem Signal am Ausgang des zugeordneten Verzögerungs-Glieds der Verzögerungs-Kette und einem Referenz-Signal erfasst, das in einer festen Phasenbeziehung zu einem ersten Ausgangssignal der Vorrichtung steht. Ferner ist eine Auswahleinrichtung vorhanden, die mit den Ausgängen der Phasendetektoren verbunden ist und die dasjenige Verzögerungs-Glied auswählt, an dessen Ausgang die durch den zugeordneten Phasendetektor erfasste Phasendifferenz mit der vorgegebenen Phasenverschiebung in grober Übereinstimmung steht. Eine Schalteinrichtung dient zum Durchschalten des Ausgangs desjenigen Verzögerungs-Glieds, welches von der Auswahleinrichtung ausgewählt wurde, um das zweite Ausgangssignal zu erzeugen.

Bei der erfindungsgemäßen Vorrichtung ist vorteilhaft, dass in der Regel nicht sämtliche Verzögerungs-Glieder der Verzögerungs-Kette im Betrieb sind, sondern nur so viele Verzögerungs-Glieder, wie dies für die Erzeugung der gewünschten Phasenverschiebung notwendig ist. Dadurch wird relativ wenig Eigenrauschen erzeugt und die Schaltung ist deshalb relativ rauscharm, denn es ist wünschenswert, dass neben dem eigentlichen Nutzsignal im Gesamtspektrum wenig Rauschenergie abseits des Nutzsignals erzeugt wird.

Außerdem kann die erfindungsgemäße Schaltung in einem großen Frequenzbereich über mehrere Oktaven hin betrieben werden. Dabei ist zu berücksichtigen, dass die Zeitverzögerung, welche für eine bestimmte Phasenverschiebung von z. B. 90° erforderlich ist, frequenzabhängig ist. Der dem der vorgegebenen Phasenverzögerung entsprechende Anteil der Periode ist zwar konstant (beispielsweise eine viertel Periode bei einer Phasenverschiebung von 90°), die zugehörige Zeitverzögerung ist aber frequenzabhängig. Durch Zuschalten von bei niedrigen Frequenzen benötigten Verzögerungs-Gliedern in der Verzögerungs-Kette bzw. durch Wegschalten bei hohen Frequenzen nicht benötigten Verzögerungs-Gliedern in der Verzögerungs-Kette wird eine große Varianz erreicht, was sich in einem großen Betriebsfrequenzbereich niederschlägt.

Werden nur relativ wenige Verzögerungs-Glieder der Verzögerungskette benutzt, so entsteht eine relativ niedrige Verlustleistung, was insbesondere bei einer hohen Integrationsdichte vorteilhaft ist. Vorteilhaft kann die von den Verzögerungs-Gliedern der Verzögerungs-Kette erzeugte Verzögerung unterschiedlich einstellt werden. Besonders bevorzugt nimmt die Verzögerung in Signallaufrichtung, d.h. vom Beginn der Verzögerungskette in Richtung auf ihr Ende, von Verzögerungs-Glied zu Verzögerungs-Glied zu. Dies hat den Vorteil, dass die von allen Signalen, d.h. sowohl von Signalen hoher Frequenz als auch von Signalen niedriger Frequenz, durchlaufenen vorderen Verzögerungs-Glieder aufgrund ihrer nur geringen Verzögerungszeit breitbandig ausgelegt werden können. Die hinteren Verzögerungs-Glieder werden nur benötigt, wenn die Betriebsfrequenz relativ niedrig ist. Diese können daher schmalbandig nur für den relativ niedrigen Frequenzbereich ausgelegt werden. Daher können diese hinteren Verzögerungs-Glieder mit relativ hoher Verzögerungszeit realisiert werden und es werden deutlich weniger Verzögerungs-Glieder benötigt, als wenn alle Verzögerungs-Glieder die gleiche Verzögerungszeit hätten, die dann notwendigerweise möglichst klein sein müsste.

Das in die Schaltung eingespeiste Signal kann beliebig geformt sein. Besonders vorteilhaft ist ein rechteckiges oder ein trapezförmiges Signal. Natürlich eigentlich sich auch ein Sinussignal. Ein rechteckiges oder trapezförmiges Signal hat bei einer digitalen Implementierung der Verzögerungs-Glieder den Vorteil, dass die Schwellwerte entweder eindeutig überschritten oder eindeutig unterschritten sind, so dass ein Rauschen einen geringen Störeinfluss hat.

Um sicherzustellen, dass auch das Referenzsignal, das aus dem Signalzweig für das erste Ausgangssignal abgezweigt ist, mindestens die Verzögerung eines Verzögerungs-Gliedes hat, ist es vorteilhaft, wenn mindestens ein Verzögerungs-Glied auch an diesem Signalzweig vorhanden ist. Um zu Erreichen, dass dieser Signalzweig ferner mit der Verzögerungszeit der Schalteinrichtung beaufschlagt wird, ist es sinnvoll, in diesen Signalzweig eine Dummy-Schalteinrichtung zu integrieren. Diese Dummy-Schalteinrichtung hat die Schaltfunktion nicht, da der Ausgang immer fest dem nur einen Eingang zugeordnet ist.

Es ist aber in der gleichen Schaltungstopologie mit den gleichen Halbleiterbauelementen strukturiert und hat somit die gleiche Übertragungsfunktion wie die reale Schalteinrichtung.

Um noch eine Feinjustierung der Phasenverschiebung vornehmen zu können, ist es vorteilhaft einen weiteren Phasendetektor vorzusehen, der das Signal am Ausgang der Schalteinrichtung mit einem zweiten Referenz-Signal vergleicht. Über eine Regeleinrichtung wird ein Stellsignal erzeugt, welches die Verzögerungszeiten der Verzögerungselemente variiert. Dabei können entweder alle Verzögerungs-Glieder einheitlich verstellt werden, z. B. durch eine gleichmäßige prozentuale Erhöhung oder Erniedrigung der Zeitverzögerung, oder es kann gezielt die Zeitverzögerung nur bestimmter Verzögerungs-Glieder verändert werden. Diese Feinjustierung der Verzögerungszeit erlaubt ein genaues Nachregeln auf die feste gewünschte Phasenverschiebung von beispielsweise 90°. Die Regeleinrichtung ist vorzugsweise als integrierender Regler (I-Regler) ausgebildet, beispielsweise als proportional integrierender Regler (PI-Regler). Dazu weist die Regeleinrichtung einen entsprechenden Integrierer auf.

Es ist vorteilhaft, am Ausgang der Vorrichtung entsprechende Pufferstufen für die Ausgangssignale vorzusehen, um zu verhindern, dass bestimmte Zustände der Vorrichtung die Impedanz am Ausgang verändern. Die Impedanz am Ausgang sollte beispielsweise unabhängig von dem Schaltzustand der Schalteinrichtung sein.

Die Erfindung wird nachfolgend unter Bezugnahme auf die Zeichnung anhand eines beispielhaften Ausführungsbeispiels erläutert. In der Zeichnung zeigen:
- Fig. 1: ein nicht erfindungsgemäßes Beispiel einer Vorrichtung zum Erzeugen einer vorgegebenen Phasenverschiebung zwischen zwei Ausgangssignalen;
- Fig. 2: ein Ausführungsbeispiel der erfindungsgemäßen Vorrichtung zur Erzeugung einer vorgegebenen Phasenverschiebung zwischen zwei Ausgangssignalen und
- Fig. 3: die Funktion der Ausgangsspannung als Funktion der Eingangsspannung an den Verzögerungs-Gliedern bei unterschiedlicher Bandbreite.

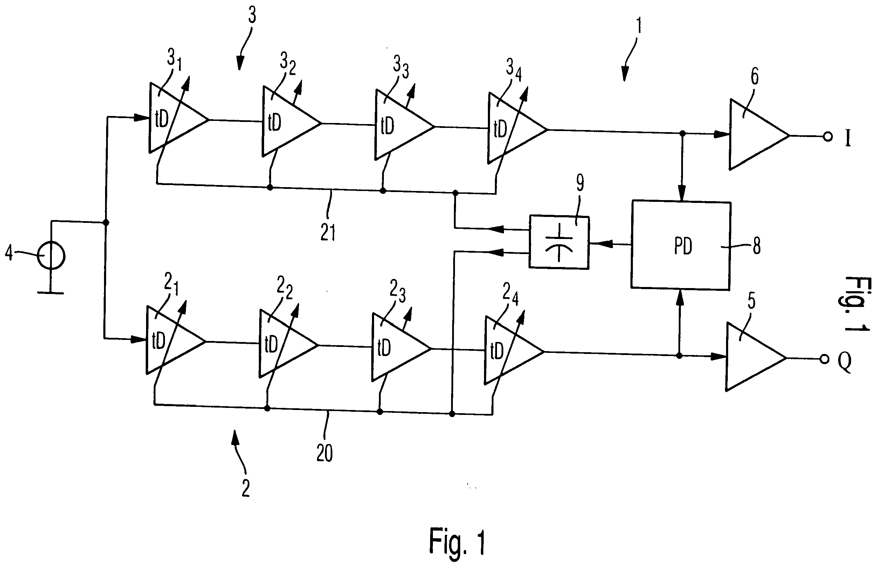

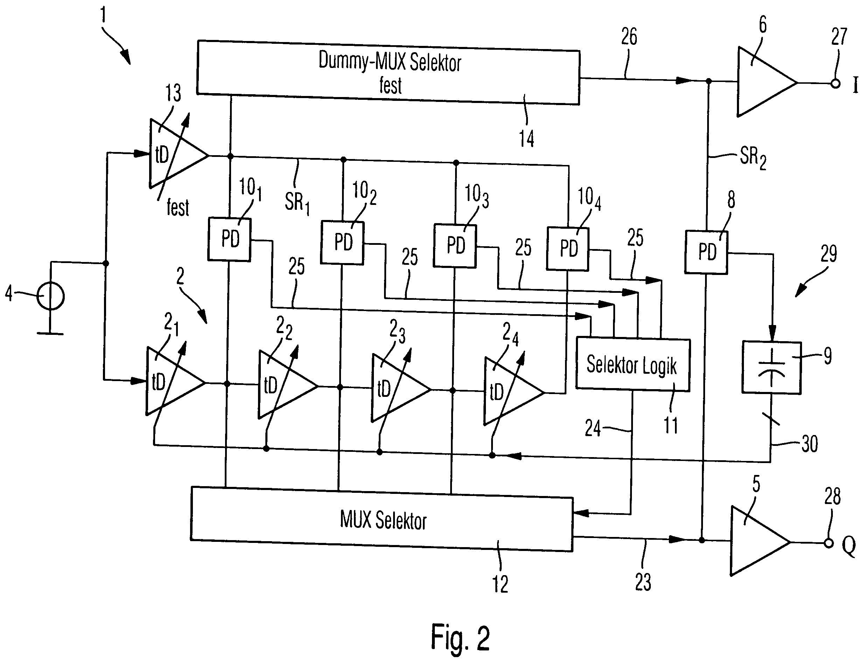

Bevor anhand von Fig. 2 auf ein erfindungsgemäßes Ausführungsbeispiel eingegangen wird, wird anhand von Fig. 1 zunächst eine nicht erfindungsgemäße Vorrichtung zum Erzeugen einer vorgegebenen Phasenverschiebung zwischen zwei Ausgangssignalen I und Q diskutiert. Diese stellt den Entwicklungsstand bei der Anmelderin vor Einführung der Erfindung dar. Es handelt sich dabei jedoch nicht um Stand der Technik, da diese Ausgestaltung öffentlich nicht zugänglich war. Die Darstellung dient nicht zur Verdeutlichung des Standes der Technik, sondern nur dazu, die erfindungsgemäßen Maßnahmen besser erläutern zu können.

Bei der in Fig. 1 dargestellten Schaltung wird das Ausgangssignal 4 sowohl einer ersten Verzögerungs-Kette 2, bestehend aus mehreren seriell hintereinander angeordneten ersten Verzögerungs-Gliedern 2₁, 2₂, 2₃ und 2₄, als auch einer zweiten Verzögerungs-Kette 3, bestehend aus mehreren seriell hintereinander angeordneten zweiten Verzögerungs-Gliedern 3₁, 3₂, 3₃ und 3₄ zugeführt. Die Verzögerungszeit der Verzögerungs-Glieder ist einheitlich, d.h. nicht unterschiedlich, und kann über eine erste Steuerleitung 20 bzw. eine zweite Steuerleitung 21 eingestellt werden. Der Ausgang eines jeden Verzögerungs-Gliedes 2₁, 2₂, 2₃ ist mit dem Eingang des in der Verzögerungs-Kette 2 nächstfolgenden Verzögerungs-Gliedes 2₂, bzw. 2₃, bzw. 2₄ verbunden. Entsprechend ist dies bei der zweiten Verzögerungskette 3 der Fall.

Der Ausgang des jeweils letzten Verzögerungs-Gliedes 2₄ der ersten Verzögerungs-Kette 2 als auch der Ausgang des letzten Verzögerungs-Gliedes 3₄ in der zweiten Verzögerungs-Kette 3 steht mit einem Phasendetektor 8 in Verbindung, welcher den Phasenunterschied zwischen dem Ausgangssignal des letzten Verzögerungs-Glieds 2₄ der ersten Verzögerungs-Kette 2 und dem Signal am Ausgang des letzten Verzögerungs-Glieds 3₄ der zweiten Verzögerungs-Kette 3 bestimmt. Dieses Signal wird als Regelsignal einem Integrierer 9 einer integrierenden Regeleinrichtung zugeführt und jeweils als Stellgröße an den beiden Steuerleitungen 20 und 21 zur Einstellung der Verzögerungs-Glieder der beiden Verzögerungs-Ketten 2 und 3 ausgegeben. Somit entsteht ein Regelkreis und der Phasendetektor 8 überwacht, dass die vorgegebene Phasenverschiebung von beispielweise 90° möglichst exakt eingehalten wird. Am Ausgang zur Ausgabe des ersten Ausgangssignals I ist ein erster Pufferverstärker 6 und am Ausgang zur Ausgabe des zweiten Ausgangssignals Q ist ein zweiter Pufferverstärker 5 vorgesehen.

Nachteilig bei der Ausgestaltung nach Fig. 1 ist, dass immer die gleiche Anzahl von Verzögerungs-Gliedern in den beiden Verzögerungs-Ketten 2 und 3 vorhanden ist. Jedes Verzögerungs-Glied trägt mit seinem Eigenrauschen jedoch zum Gesamtrauschen der Schaltung bei. Deshalb ist es vorteilhaft, möglichst wenige Verzögerungs-Glieder zu verwenden. Ein weiteres Problem besteht darin, dass jedes einzelne Verzögerungs-Glied keine hohe Verzögerungszeit haben kann, wenn eine breitbandige Ausgestaltung erwünscht ist. Denn eine große Verzögerungszeit bedingt eine kleine Flankensteilheit der Übertragungsfunktion des Verzögerungs-Glieds, was zu einem schmalbandigen Kleinsignalverhalten führt. Wenn alle Verzögerungs-Glieder sowohl für niedrige Betriebsfrequenzen als auch für hohe Betriebsfrequenzen des Eingangssignals ausgelegt werden, bedingt dies, dass alle Verzögerungs-Glieder notwendigerweise breitbandig sein müssen, und somit für alle Verzögerungs-Glieder nur eine relativ kleine Verzögerungszeit realisiert werden kann. Deshalb ist die zu verwendende Anzahl der Verzögerungs-Glieder relativ hoch, dies führt zu einem relativ großen Eigenrauschen und zu einer relativ großen Verlustleistung.

Fig. 2 zeigt ein Ausführungsbeispiel der erfindungsgemäßen Vorrichtung zum Erzeugen einer vorgegebenen Phasenverschiebung zwischen zwei Ausgangssignalen I und Q. Bereits anhand von Fig. 1 beschriebene Elemente sind mit übereinstimmenden Bezugszeichen versehen. Dies erleichtert die Zuordnung und eine wiederholende Beschreibung erübrigt sich insoweit.

Auch bei dem in Fig. 2 dargestellten Ausführungsbeispiel ist die Signalquelle 4 mit einer Verzögerungs-Kette 2 verbunden, die aus mehreren hintereinander geschaltenen Verzögerungs-Gliedern 2₁, 2₂, 2₃ und 2₄ besteht. Der Eingang des ersten Verzögerungs-Glieds 2₁ ist mit der Signalquelle 4 verbunden. Der Ausgang des ersten Verzögerungs-Glieds 2₁ ist sowohl mit dem Eingang des zweiten Verzögerungs-Glieds 2₂ als auch mit dem Eingang eines ersten Phasendetektors 10₁ verbunden. Entsprechend ist der Ausgang des zweiten Verzögerungs-Glieds 2₂ sowohl mit dem Eingang eines dritten Verzögerungs-Glieds 2₃ als auch mit einem Eingang eines zweiten Phasendetektors 10₂ verbunden. Entsprechend ist der Ausgang des dritten Verzögerungs-Glieds 2₃ sowohl mit dem Eingang eines vierten Verzögerungs-Glieds 2₄ als auch mit einem Eingang eines dritten Phasendetektors 10₃ verbunden. Im vereinfachten Ausführungsbeispiel der Fig. 2 ist das vierte Verzögerungs-Glied 2₄ das letzte Verzögerungs-Glied. Bei einem realen Ausführungsbeispiel sind jedoch sehr viele Verzögerungsstufen mit entsprechenden Verzögerungs-Gliedern vorhanden, beispielsweise mehrere hundert Verzögerungs-Glieder. Der Ausgang des letzten Verzögerungs-Glieds 2₄ ist mit einem letzten Phasendetektor 10₄ an einem dessen Eingänge verbunden.

Der zweite Eingang der Phasendetektoren 10₁, 10₂, 10₃ und 10₄ steht im Ausführungsbeispiel mit dem Ausgang eines einzigen Verzögerungs-Glieds 13 für das erste Ausgangssignal I in Verbindung, dessen Eingang ebenfalls mit der Signalquelle 4 verbunden ist. Dieses Verzögerungs-Glied 3 hat im Ausführungsbeispiel eine feste, also nicht variierbare Zeitverzögerung. Das Ausgangssignal dieses Verzögerungs-Glieds 13 wird als erstes Referenz-Signal SR₁ verwendet und allen Phasendetektoren 10₁, 10₂, 10₃ und 10₄ zugeführt. Jeder Phasendetektor 10₁, 10₂, 10₃ und 10₄ vergleicht die Phase des Ausgangssignals am Ausgang des jeweils zugeordneten Verzögerungs-Glieds 2₁, 2₂, 2₃ bzw. 2₄ mit der Phase des ersten Referenzsignals SR₁. Dieser Vergleich wird in ein Steuersignal abgebildet, dass eine Auswahleinrichtung 11 zugeführt wird, die in der Fig. 2 als Selektor Logik bezeichnet ist. Ferner ist eine Schalteinrichtung 12 vorgesehen, die den Ausgang desjenigen Verzögerungs-Gliedes 2₁ bzw. 2₂ bzw. 2₃ bzw. 2₄ an eine Ausgangsleitung 23 in Abhängigkeit von dem Ergebnis der Auswahleinrichtung 11 durchschaltet. Dazu ist die Auswahleinrichtung 11 über eine Steuerleitung 24 mit der Schalteinrichtung 12 verbunden. Die Phasendetektoren 10₁, 10₂, 10₃ und 10₄ sind über Signalleitungen 25 mit der Auswahleinrichtung 11 verbunden.

Anstatt der Auswahleinrichtung 12 ist in dem Signalzweig für das erste Ausgangssignal I nur eine Dummy-Schalteinrichtung 14, d.h. eine nachgebildete Schalteinrichtung, vorhanden. Diese Dummy-Schalteinrichtung 14 kann ggf. auch weggelassen werden. Ihre Einfügung in den Signalweg hat jedoch den Vorteil, dass das Signal des ersten Ausgangssignals I im Wesentlichen der gleichen Signalbearbeitung wie das Signal des zweiten Ausgangssignals Q unterworfen ist, d.h. es sind im Wesentlichen die gleichen oder ähnliche Halbleiterbauelemente einer integrierten Schaltung vorhanden. Insbesondere hat die Dummy-Schalteinrichtung 14 in etwa die gleiche Signalverzögerung wie die reale Schalteinrichtung 12. Der Eingang der Dummy-Schalteinrichtung 14 ist mit dem Ausgang des Verzögerungs-Glieds 13 verbunden. Der Ausgang der Dummy-Schalteinrichtung 14 ist mit einer Ausgangsleitung 26 verbunden, die über eine zweite Pufferstufe 6 mit dem Ausgang 27 zur Ausgabe des ersten Ausgangssignals I in Verbindung steht. Entsprechend ist die Ausgangsleitung 23 der Schalteinrichtung 14 über eine zweite Pufferstufe 5 mit einem Ausgang 28 zur Ausgabe des zweiten Ausgangssignals Q verbunden.

Die Ausgangsleitung 23 der Schalteinrichtung 12 und die Ausgangsleitung 26 der Dummy-Schalteinrichtung 14 sind jeweils mit den Eingängen eines weiteren Phasendetektors 8 verbunden. Dieser Phasendetektor 8 vergleicht die Phase des Signals auf der Ausgangsleitung 23 der Schalteinrichtung 12 mit der Phase des als zweites Referenzsignal SR₂ dienenden Signals auf der Ausgangsleitung 26 der Dummy-Schalteinrichtung 14. Ein dem Phasenvergleich entsprechendes Steuersignal wird dem Integrierer 9 einer Regeleinrichtung 29 zugeführt. Der Integrier 9 der Regeleinrichtung 29 steht über einen Steuerbus 30 mit den Verzögerungs-Gliedern 2₁ bis 2₄ in Verbindung. Die Regeleinrichtung 29 verstellt in Abhängigkeit von dem Ergebnis des Phasenvergleichs des Phasendetektors 8 die einzelnen Verzögerungszeiten der Verzögerungs-Glieder 2₂ bis 2₄ der Verzögerungskette 2. Dabei ist es bei einem bevorzugten Ausführungsbeispiel auch möglich, nicht alle Verzögerungs-Glieder gleichmäßig zu verstellen, sondern beispielsweise nur die, Verzögerungs-Glieder, die von dem Signal tatsächlich durchlaufen werden. Beispielweise ist es möglich, wenn das Signal alle oder nahezu alle Verzögerungs-Glieder durchläuft, alle bzw. nahezu alle Verzögerungs-Glieder wenig zu verstellen, während in einer Schaltsituation, bei welcher nur wenige Verzögerungs-Glieder durchlaufen werden, alle diese tatsächlich durchlaufenden Verzögerungs-Glieder relativ stark verstellt werden.

Während die Auswahleinrichtung 11 und die Schalteinrichtung 12 der groben Einstellung der Phasenverschiebung dienen, kann mit der Regeleinrichtung 29 eine Feineinstellung vorgenommen werden. Die Auswahleinrichtung 11 schaltet dabei mittels der Schalteinrichtung 12 denjenigen Ausgang eines Verzögerungs-Glieds 2₁ bis 2₄ zu der Ausgangsleitung 23 durch, die grob mit der vorgegebenen Phasenverschiebung übereinstimmt. Soll beispielsweise eine Phasenverschiebung von exakt 90° erreicht werden und wird durch jedes von 100 aneinander gereihten Verzögerungselementen eine Phasenverschiebung von ca. 1° erreicht, so wird beispielsweise entweder das 89., 90. oder 91. Verzögerungs-Glied zur Ausgangsleitung 23 durchgeschaltet, je nachdem wie hoch die Phasenverschiebung der Verzögerungs-Glieder in Abhängigkeit von Fabrikations-Parametern oder der Temperatur in der Realität tatsächlich ist. Ein Feinabgleich wird dadurch vorgenommen, dass die Verzögerungszeit der Verzögerungs-Glieder mittels der Regeleinrichtung 29 nachgeregelt wird.

Die in einer DLL-Schaltung produzierte und zum Ausgang übertragene Rauschleistung in der Verzögerungs-Kette hängt von der Anzahl der Verzögerungselemente in der Kette sowie von der Flankensteilheit der Signale im Nulldurchgang, d.h. vom Kleinsignalverhalten ab. Um die Rauschleistung minimal zu halten muss die Flankensteilheit maximiert werden und andererseits die Anzahl der Verzögerungs-Glieder minimiert werden. Um hingegen eine möglichst große Verzögerung für den Betrieb bei niedrigen Frequenzen zu ermöglichen, bedarf es andererseits einer möglichst großen Anzahl von Verzögerungs-Gliedern und einer möglichst großen Verzögerung der einzelnen Verzögerungs-Glieder. Wie bereits beschrieben, nimmt jedoch die Verzögerung der einzelnen Verzögerungs-Glieder mit zunehmender Flankensteilheit ab. Es handelt sich dabei also um gegenläufige Anforderungen.

Diese gegenläufigen Forderungen werden durch die erfindungsgemäßen Maßnahmen erfüllt, weil nur so viele Verzögerungs-Glieder zugeschaltet sind, wie sie tatsächlich aufgrund der gewünschten Phasenverschiebung und der Betriebsfrequenz, d.h. der Frequenz des von dem Signalgenerator 4 erzeugten Eingangssignals, gerade benötigt werden.

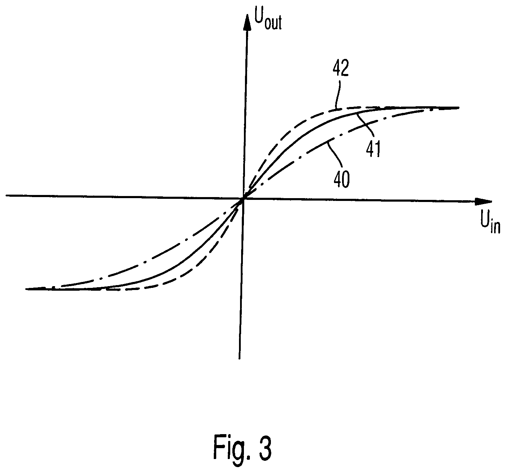

Die Flankensteilheit sei anhand von Fig. 3 erläutert. Dargestellt ist die Ausgangsspannung Uₒᵤₜ am Ausgang eines der Verzögerungs-Glieder 2₁ bis 2₄ als Funktion der Eingangsspannung Uᵢₙ am Eingang eines der Verzögerungselemente 2₁ bis 2₄. Die Kurve 40 zeigt die Übertragungsfunktion mit einer nur geringen Flankensteilheit im Nulldurchgang, die Kurve 41 zeigt eine Übertragungsfunktion mit einer mittleren Flankensteilheit im Nulldurchgang, während die Funktion 42 die Übertragungsfunktion mit einer hohen Flankensteilheit im Nulldurchgang zeigt.

Um die minimalste Phasenverschiebung zu erreichen, muss die intrinsische feste Phasenverzögerung des ersten Verzögerungs-Glieds 2₁ der Verzögerungskette 2 und der Schalteinrichtung 12 ausgeglichen werden. Deshalb sind im Signalpfad des ersten Ausgangssignals I ein Verzögerungs-Glied 13 und eine Dummy-Schalteinrichtung 14 vorhanden.

Da die für eine bestimmte Phasenverschiebung notwendige Verzögerung mit steigender Frequenz abnimmt, reichen bei relativ hohen Betriebsfrequenzen wenige Verzögerungs-Glieder aus. Bei einer relativ niedrigen Betriebsfrequenz müssen hingegen viele Verzögerungs-Glieder betrieben werden, bevor der Abgriff für das Ausgangssignal Q erfolgt. Dies kann berücksichtigt werden, in dem die ersten Verzögerungs-Glieder in der Verzögerungs-Kette 2 mit maximal benötigter Bandbreite ausgelegt werden und zum Ende der Verzögerungs-Kette 2 hin die einstellbare Zeitverzögerung der Verzögerungs-Glieder erhöht wird, was einer Erniedrigung der Kleinsignalbandbreite entspricht.

Die Erfindung ist nicht auf das dargestellte Ausführungsbeispiel beschränkt. Beispielsweise sind das Verzögerungs-Glied 13, die Dummy-Schalteinrichtung 14 und die Pufferstufen 5 und 6 nicht zwingend notwendig. Wenn die Verzögerungs-Kette 2 aus ausreichend vielen Verzögerungs-Gliedern besteht, bzw. keine allzu hohen Anforderungen an die Genauigkeit der Phasenverschiebung bestehen, kann auf die Feinregelung auch verzichtet werden. Dann können der Phasendetektor 8 und die Regeleinrichtung 29 mit dem Integrierer 9 entfallen. Auch müssen dann die Verzögerungs-Glieder der Verzögerungs-Kette nicht veränderlich ausgebildet sein.

## Patentansprüche

1. Vorrichtung (1) zum Erzeugen einer vorgegebenen Phasenverschiebung zwischen zwei Ausgangssignalen (I,Q) mit
einer Verzögerungs-Kette (2) aus mehreren seriell hintereinander angeordneten Verzögerungs-Gliedern (2₁-2₄),
wobei mehrere Phasendetektoren (10₁-10₄) jeweils zum Erfassen der Phasendifferenz zwischen dem Signal am Ausgang eines zugeordneten Verzögerungs-Glieds (2₁-2₄) und einem ersten Referenz-Signal (SR₁), das in einer festen Phasenbeziehung zum ersten Ausgangssignal (I) steht,
**dadurch gekennzeichnet,**
**dass** die von den Verzögerungs-Gliedern (2₁-2₄) der Verzögerungs-Kette (2) erzeugte Verzögerung unterschiedlich ist und in Signallaufrichtung von Verzögerungs-Glied zu Verzögerungs-Glied zunimmt und dass nur soviele Verzögerungsglieder (2₁-2₄) in Betrieb sind, wie dies für die Erzeugung der gewünschten Phasenverschiebung notwendig ist,
**dass** eine Auswahleinrichtung (11) vorhanden ist, die mit den Ausgängen der Phasendetektoren (10₁-10₄) in Verbindung steht und die dasjenige Verzögerungs-Glied (2₁-2₄) auswählt, an dessen Ausgang die durch den zugeordneten Phasendetektor (10₁-10₄) erfasste Phasendifferenz mit der vorgegebenen Phasenverschiebung in grober Übereinstimmung steht, und dass eine Schalteinrichtung (12) zum Durchschalten des Ausgangs desjenigen Verzögerungs-Gliedes (2₁-2₄) vorhanden ist, welches von der Auswahleinrichtung (11) ausgewählt wurde, um das zweite Ausgangssignal (Q) zu erzeugen.

2. Vorrichtung nach Anspruch 1,
**dadurch gekennzeichnet,**
**dass** die Bandbreite der Verzögerungs-Glieder (2₁-2₄) der Verzögerungs-Kette (2) unterschiedlich ist und in Signallaufrichtung von Verzögerungs-Glied zu Verzögerungs-Glied abnimmt.

3. Vorrichtung nach einem der Ansprüche 1 oder 2,
**dadurch gekennzeichnet,**
**dass** ein erstes Verzögerungs-Glied (2₁) der Verzögerungs-Kette an einer Signalquelle (4) angeschlossen ist.

4. Vorrichtung nach Anspruch3,
**dadurch gekennzeichnet,**
**dass** die Signalquelle (4) ein rechteckiges oder trapezförmiges Signal erzeugt.

5. Vorrichtung nach Anspruch 3 oder 4,
**dadurch gekennzeichnet,**
**dass** die Signalquelle (4) mit einem weiteren Verzögerungselement (13) für das erste Ausgangssignal (I) verbunden ist.

6. Vorrichtung nach Anspruch 5,
**dadurch gekennzeichnet,**
**dass** am Ausgang des weiteren Verzögerungselements (13) das erste Referenz-Signal (SR₁) ansteht.

7. Vorrichtung nach Anspruch 5 oder 6 und 1,
**dadurch gekennzeichnet,**
**dass** dem weiteren Verzögerungselement (13) eine Dummy-Schalteinrichtung (14) nachgeschaltet ist, welche die gleiche Verzögerung wie die Schalteinrichtung (12) aufweist.

8. Vorrichtung nach Anspruch 1,
**dadurch gekennzeichnet,**
**dass** ein weiterer Phasendetektor (8) vorhanden ist, zum Erfassen der Phasendifferenz zwischen dem Signal am Ausgang der Schalteinrichtung (12) und einem zweiten Referenz-Signal (SR₂), das in einer festen Phasenbeziehung zum ersten Ausgangssignal (I) steht.

9. Vorrichtung nach Anspruch 8,
**dadurch gekennzeichnet,**
**dass** am Ausgang der Dummy-Schalteinrichtung (14) das zweite Referenz-Signal (SR₂) ansteht.

10. Vorrichtung nach Anspruch 8 oder9,
**dadurch gekennzeichnet,**
**dass** das Ausgangssignal des weiteren Phasendetektors (8) als Stellsignal für eine Regeleinrichtung (29) zur Regelung der Verzögerung eines oder mehrerer Verzögerungs-Glieder (2₁-2₄) der Verzögerungs-Kette (2) dient.

11. Vorrichtung nach Anspruch 10,
**dadurch gekennzeichnet,**
**dass** die Regeleinrichtung (29) einen Integrierer (9) aufweist.

12. Vorrichtung nach einem der Ansprüche 1 bis 11,
**dadurch gekennzeichnet,**
**dass** das erste Ausgangssignal (I) über eine erste Pufferstufe (5) und das zweite Ausgangssignal (Q) über eine zweite Pufferstufe (5) dem jeweiligen Ausgang (27; 28) zugeführt ist.

## Claims

1. Device for generating a pre-defined phase shift between two output signals (I, Q) with a delay chain (2) comprising a plurality of delay elements (2₁-2₄) arranged serially one behind another,
wherein a plurality of phase detectors (10₁-10₄) are present each for detection of the phase difference between the signal at the output of an associated delay element (2₁-2₄) and a first reference signal (SR₁) which is in a fixed phase relationship to the first output signal (I),
**characterised in that**
the delay generated by the delay elements (2₁-2₄) of the delay chain (2) is different and increases in the signal travel direction from delay element to delay element and
**in that** only as many delay elements (2₁-2₄) are in operation as is necessary for generation of the desired phase shift,
**in that** a selection unit (11) is present which communicates with the outputs of the phase detectors (10₁-10₄) and selects the delay element (2₁-2₄) at the output of which the phase difference detected by the associated phase detector (10₁-10₄) roughly matches the pre-defined phase shift, and **in that** a switching unit (12) is present for switching through the output of the delay element (2₁-2₄) which was selected by the selection unit (11) in order to generate the second output signal (Q) .

2. Device according to claim 1,
**characterised in that**
the band width of the delay elements (2₁-2₄) in the delay chain (2) is different and decreases in the signal travel direction from delay element to delay element.

3. Device according to one of claims 1 or 2,
**characterised in that**
a first delay element (2₁) of the delay chain is connected to a signal source (4).

4. Device according to claim 3,
**characterised in that**
the signal source (4) generates a rectangular or trapezoidal signal.

5. Device according to claim 3 or 4,
**characterised in that**
the signal source (4) is connected with a further delay element (13) for the first output signal (I).

6. Device according to claim 5,
**characterised in that**
the first reference signal (SR₁) appears at the output of the further delay element (13).

7. Device according to claim 5 or 6 and 1,
**characterised in that**
connected downstream of the further delay element (13) there is a dummy switching unit (14) which has the same delay as the switching unit (12).

8. Device according to claim 1,
**characterised in that**
a further phase detector (8) is present for detecting the phase difference between the signal at the output of the switching unit (12) and a second reference signal (SR₂) which is in a fixed phase relationship to the first output signal (I).

9. Device according to claim 8,
**characterised in that**
the second reference signal (SR₂) appears at the output of the dummy switching unit (14).

10. Device according to claim 8 or 9,
**characterised in that**
the output signal of the further phase detector (8) is used as a setting signal for a control unit (29) for controlling the delay of one or more delay elements (2₁-2₄) of the delay chain (2).

11. Device according to claim 10,
**characterised in that**
the control unit (29) comprises an integrator (9).

12. Device according to one of claims 1 to 11,
**characterised in that**
the first output signal (I) is fed via a first buffer stage (5) and the second output signal (Q) is fed via a second buffer stage (5) to the respective output (27; 28).

## Revendications

1. Dispositif (1) de production d'un décalage de phase prédéfini entre deux signaux de sortie (I, Q), comprenant
une chaîne de retard (2) composée de plusieurs éléments de retard (2₁-2₄) agencés en série les uns derrière les autres,
dans lequel plusieurs détecteurs de phase (10₁-10₄) sont conçus chacun pour détecter la différence de phase entre le signal à la sortie d'un élément de retard (2₁-2₄) associé et un premier signal de référence (SR₁), qui se trouve dans une relation de phase fixe par rapport au premier signal de sortie (I),
**caractérisé**
**en ce que** le retard produit par les éléments de retard (2₁-2₄) de la chaîne de retard (2) est différent et augmente dans la direction de trajet du signal d'un élément de retard à un autre et
**en ce que** seul le nombre d'éléments de retard (2₁-2₄) nécessaire à la production du décalage de phase souhaité est en fonctionnement,
**en ce qu'**un dispositif de sélection (11) est présent, qui est relié aux sorties des détecteurs de phase (10₁-10₄) et qui sélectionne l'élément de retard (2₁-2₄) à la sortie duquel la différence de phase détectée par le détecteur de phase (10₁-10₄) associé concorde dans l'ensemble avec le décalage de phase prédéfini,
et **en ce qu'**un dispositif de commutation (12) est présent et est destiné à commuter la sortie de l'élément de retard (2₁-2₄) qui a été sélectionné par le dispositif de sélection (11), afin de produire le deuxième signal de sortie (Q).

2. Dispositif selon la revendication 1,
**caractérisé**
**en ce que** la bande passante des éléments de retard (2₁-2₄) de la chaîne de retard (2) est différente et diminue dans la direction du trajet du signal d'un élément de retard à un autre.

3. Dispositif selon l'une quelconque des revendications 1 ou 2,
**caractérisé**
**en ce qu'**un premier élément de retard (2₁) de la chaîne de retard est raccordé à une source de signal (4) .

4. Dispositif selon la revendication 3,
**caractérisé**
**en ce que** la source de signal (4) produit un signal rectangulaire ou trapézoïdal.

5. Dispositif selon la revendication 3 ou 4,
**caractérisé**
**en ce que** la source de signal (4) est reliée à un autre élément de retard (13) pour le premier signal de sortie (I).

6. Dispositif selon la revendication 5,
**caractérisé**
**en ce que** le premier signal de référence (SR₁) est présent à la sortie de l'autre élément de retard (13).

7. Dispositif selon la revendication 5 ou 6 et 1,
**caractérisé**
**en ce qu'**un dispositif de commutation factice (14), lequel présente le même retard que le dispositif de commutation (12), est branché en aval de l'autre élément de retard (13).

8. Dispositif selon la revendication 1,
**caractérisé**
**en ce qu'**un autre détecteur de phase (8) est présent, et est destiné à détecter la différence de phase entre le signal à la sortie du dispositif de commutation (12) et un deuxième signal de référence (SR₂), qui se trouve dans une relation de phase fixe par rapport au premier signal de sortie (I).

9. Dispositif selon la revendication 8,
**caractérisé**
**en ce que** le deuxième signal de référence (SR₂) est présent à la sortie du dispositif de commutation factice (14).

10. Dispositif selon la revendication 8 ou 9,
**caractérisé**
**en ce que** le signal de sortie de l'autre détecteur de phase (8) sert de signal de réglage pour un dispositif de régulation (29) destiné à réguler le retard d'un ou de plusieurs éléments de retard (2₁-2₄) de la chaîne de retard (2).

11. Dispositif selon la revendication 10,
**caractérisé**
**en ce que** le dispositif de régulation (29) comprend un intégrateur (9).

12. Dispositif selon l'une quelconque des revendications 1 à 11,
**caractérisé**
**en ce que** le premier signal de sortie (I) est amené à la sortie (27 ; 28) respective par l'intermédiaire d'un premier étage tampon (5) et le deuxième signal de sortie (Q) est amené à la sortie (27 ; 28) respective par l'intermédiaire d'un deuxième étage tampon (5).
